(19) Europäisches Patentamt / European Patent Office / Office européen des brevets

(11) **EP 2 122 373 B1**

(12) **FASCICULE DE BREVET EUROPEEN**

(45) Date de publication et mention
de la délivrance du brevet:
**24.12.2014 Bulletin 2014/52**

(21) Numéro de dépôt: **08708893.6**

(22) Date de dépôt: **12.02.2008**

(51) Int Cl.:
***G01R 29/08*** *(2006.01)*          ***H01P 1/207*** *(2006.01)*
***H01P 1/06*** *(2006.01)*

(86) Numéro de dépôt international:
**PCT/EP2008/051651**

(87) Numéro de publication internationale:
**WO 2008/101834 (28.08.2008 Gazette 2008/35)**

(54) **ANTENNE ADAPTABLE POUR ESSAIS DE COMPATIBILITE ELECTROMAGNETIQUE**

AN ELEKTROMAGNETISCHE KOMPATIBILITÄTSPRÜFUNG ANPASSBARE ANTENNE

ANTENNA ADAPTABLE TO ELECTROMAGNETIC COMPATIBILITY TESTING

(84) Etats contractants désignés:
**AT BE BG CH CY CZ DE DK EE ES FI FR GB GR
HR HU IE IS IT LI LT LU LV MC MT NL NO PL PT
RO SE SI SK TR**

(30) Priorité: **14.02.2007 FR 0753258**

(43) Date de publication de la demande:
**25.11.2009 Bulletin 2009/48**

(73) Titulaire: **Airbus Operations
31060 Toulouse (FR)**

(72) Inventeur: **GODARD, Maël
92358 Le Plessis-Robinson (FR)**

(74) Mandataire: **Ilgart, Jean-Christophe et al
BREVALEX
95, rue d'Amsterdam
75378 Paris Cedex 8 (FR)**

(56) Documents cités:
**EP-A1- 0 003 463      FR-A- 958 781
US-A- 3 806 943      US-A- 5 585 808**

**Description**

**DOMAINE TECHNIQUE ET ART ANTÉRIEUR**

La présente invention se rapporte à une antenne pour effectuer des essais de comptabilité électromagnétique (CEM).

Les différents équipements électroniques d'un avion ou d'un véhicule automobile, interagissent de façon électromagnétique entre eux et avec leur environnement. Ils perturbent dans une certaine mesure cet environnement et présentent à leur tour une certaine susceptibilité vis-à-vis des agressions électromagnétiques.

L'environnement électromagnétique, dont le degré de pollution est variable en fonction des situations, comprend toutes les menaces électromagnétiques potentielles, par exemple les commutations de courants forts, les transitoires sur les réseaux d'énergie, les émetteurs de radiodiffusion, les réseaux de télécommunications hertziens, les impulsions radars, les décharges électrostatiques, les décharges de foudre, le bruit cosmique ou encore les impulsions électromagnétiques d'origine nucléaire.

Il est alors nécessaire, afin de pouvoir garantir le fonctionnement des différents équipements électroniques destinés à fonctionner à proximité les uns des autres, de vérifier la compatibilité électromagnétique (CEM) lors des étapes de conception jusqu'aux étapes de validation et d'intégration des systèmes comportant ces équipements électromagnétiques. La vérification de la CEM vise donc à garantir le bon fonctionnement d'un équipement électronique en présence de nombreux autres et ceci dans un environnement électromagnétique souvent hostile.

Une telle vérification impose donc la mise en place d'un certain nombre d'essais CEM adaptés à chaque étape du processus de développement.

Ces essais peuvent être classés en quatre catégories :

- les essais d'émission conduite,
- les essais de susceptibilité conduite,
- les essais d'émission rayonnée, et
- les essais de susceptibilité rayonnée. Les essais d'émission permettent de vérifier que l'équipement électronique n'émet pas de parasites au-delà d'une certaine limite jugée acceptable ; les essais de susceptibilités permettent de vérifier que l'équipement électronique est suffisamment immunisé vis-à-vis de parasites.

Un équipement électronique du type calculateur comporte plusieurs cartes électroniques comportant elles-mêmes plusieurs composants électroniques destinés à communiquer entre eux.

Lors des essais de susceptibilités, il est contrôlé si les différents composants électroniques dialoguent correctement ensemble en présence d'un champ électromagnétique.

L'art antérieur US 5585808 décrit une un appareil de test électromagnétique d'équipement électronique.

Pour effectuer des essais de susceptibilité rayonnée, il est connu d'utiliser des antennes dites Strip-line permettant de créer un champ magnétique pour illuminer les cartes électroniques.

Une antenne Strip-line forme une enceinte à l'intérieur de laquelle un champ électromagnétique donné et relativement uniforme peut être créé. Les cartes électroniques sont disposées à l'intérieur de cette enceinte et sont donc exposées au champ électromagnétique donné. On vérifie alors pendant cette exposition le comportement des cartes électroniques.

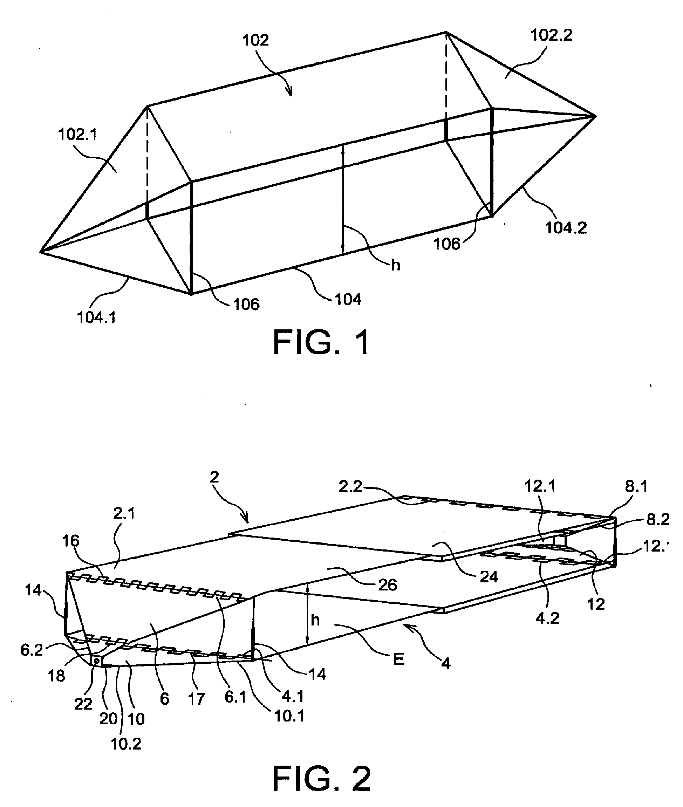

L'antenne Strip-line de type connu, dont un exemple est représenté sur la figure 1, comporte deux plaques métalliques 102, 104 parallèles en regard, chacune de deux extrémités longitudinales 102.1, 102.2, 104.1, 104.2 de forme triangulaire, chaque extrémité triangulaire 102.1, 102.2, 104.1, 104.2 d'une plaque 102, 104 se rapprochant d'extrémité triangulaire de l'autre plaque 104, 102 disposée du même côté. Ainsi, vue de devant, l'antenne a la forme d'un hexagone ayant deux côtés parallèles de plus grandes longueurs formés par les plaques parallèle 102, 104 , les autres côtés parallèles deux à deux et de plus petite longueurs étant formés par les extrémités triangulaires 102.1, 102.2, 104.1, 104.2.

Les plaques 102, 104 sont séparées d'une distance donnée fixe au moyen d'entretoises isolantes 106 de hauteur h.

Les différentes pièces formant l'antenne sont immobiles les unes par rapport aux autres dans une configuration figée.

Une extrémité longitudinale est attaquée par un amplificateur de puissance radio fréquence, et la seconde extrémité est chargée sur une résistance de puissance, d'impédance de 50 ohms.

Le champ formé à l'intérieur de cette antenne est de polarisation verticale. La valeur du champ en volts par mètre (V/m) est fonction de la hauteur h et est donnée par la relation suivante :

$$|E| = \frac{\sqrt{PZ}}{h} \qquad\qquad (\mathrm{I})$$

P étant la puissance injectée en Watts,
Z étant l'impédance antenne, et
h étant la distance séparant les plaques supérieure 102, 104.

Le champ est uniforme dans l'espace situé entre les plaques 102, 104 jusqu'à la fréquence de coupure $f_{c10}$, fréquence à laquelle l'antenne fonctionne en résonances multiples et non plus en résonance simple. Cette fréquence de coupure est donnée par la relation suivante :

$$f_{c10} = \frac{c}{\lambda_{c10}} = \frac{c}{2L} \qquad\qquad (\mathrm{II})$$

c étant la célérité, et
L la largeur de l'antenne, i.e. la largeur des plaques parallèles 102, 104.

L'uniformité du champ est ainsi assurée jusqu'à cette fréquence de coupure ; au-delà de cette fréquence, la strip-line peut être utilisée mais il convient de vérifier l'uniformité du champ dans la zone de test à l'aide d'une sonde et d'un wattmètre afin de s'assurer que la valeur du champ est en tout point égale ou supérieure à la spécification demandée.
L'avantage de ce type d'antenne est de permettre l'obtention d'un fort champ sur une gamme étendue de fréquences. Le fait d'être large bande limite le nombre d'antennes à acheter et réduit le temps d'installation. Les essais sont ainsi réalisés plus rapidement qu'en cas d'utilisation d'antennes à bande passante étroite.
Cependant, les antennes Strip-line de l'état de la technique sont de taille fixe. La puissance disponible à l'amplificateur n'est donc pas utilisée de manière optimale, lors de la mise en oeuvre d'une antenne surdimensionnée par rapport à des cartes électroniques à tester. Par ailleurs, la valeur du champ électromagnétique obtenue à l'intérieur de l'antenne est limitée.
Il est donc nécessaire pour ce type d'antenne d'augmenter la puissance de l'amplificateur pour compenser l'espace entre les plaques. Or, au vu de la relation (I), on constate que le champ électromagnétique est proportionnel à la racine de la puissance. Il est donc nécessaire d'augmenter de manière importante la puissance pour avoir une augmentation significative du champ.
Par ailleurs, le prix de revient des amplificateurs Haute Fréquence est élevé, et une augmentation de leur puissance augmente leur coût de manière importante.
En outre, ce type d'antenne Strip-line lorsqu'elle fonctionne au-delà de sa fréquence de coupure fixe, présente des modes de résonance non déplaçables.
C'est par conséquent un but de la présente invention d'offrir une antenne pour effectuer des essais de susceptibilité rayonnée optimisée pour différentes cartes électroniques dont le coût de revient est réduit.
C'est également un but de la présente invention d'offrir une antenne pour effectuer des essais de susceptibilité rayonnée ayant au-delà de la fréquence de coupure des modes de résonance déplaçables.

## EXPOSÉ DE L'INVENTION

Le but précédemment énoncé est atteint par une antenne de type strip-line, de dimensions variables, notamment apte à offrir un espace entre les deux plaques parallèles variables afin d'utiliser la puissance de l'amplificateur de manière optimale. On évite alors de devoir recourir à des amplificateurs de puissance plus élevée.
En effet, au vu de la relation (I), le champ magnétique est inversement proportionnel à la distance séparant les plaques parallèles. Ainsi, il est aisé avec une antenne dont la hauteur est variable d'utiliser au mieux la puissance maximale délivrable par l'amplificateur.
L'antenne peut également être de longueur variable, c'est-à-dire que les plaques parallèles sont extensibles dans le sens longitudinal. Ainsi, les modes de résonance dans le cas d'utilisation de l'antenne au-delà de cette fréquence de coupure peuvent être déplacés.
La présente invention a alors principalement pour objet une antenne pour essais de compatibilité électromagnétique tel que décrite par la revendication 1.

De manière avantageuse, la plaque supérieure et la plaque inférieure sont maintenues à une distance prédéterminée au moyen d'entretoises de hauteur variable. Les entretoises peuvent alors être du type télescopique.

Par exemple, les plaques longitudinales sont montées mobiles au moyen de premières liaisons pivots sur des extrémités longitudinales de la plaque supérieure de manière à pouvoir modifier la distance séparant les plaques supérieure et inférieure. Ceci permet d'optimiser l'utilisation de la puissance maximale que peut délivrer l'amplificateur.

Les premières liaisons pivots sont par exemple en matériau conducteur électrique pour assurer la conductivité entre la plaque supérieure et les plaques longitudinales et entre la plaque inférieure et les plaques longitudinales.

Il peut avantageusement être prévu que l'antenne selon la présente invention comporte au moins une plaque supérieure de dimension longitudinale variable, ou qu'à la fois la plaque supérieure et la plaque inférieure soient de dimension longitudinale variable. Grâce la présente invention, les modes de résonance lorsque l'antenne fonctionne au-delà de sa fréquence de coupure de l'antenne peuvent être modifiés.

Les plaques de dimension longitudinales variables sont par exemple du type télescopique, comportant une partie mâle et une partie femelle, les parties mâle et femelle étant en contact électrique permanent.

Il peut être prévu que la partie mâle de la plaque supérieure soit en regard de la partie mâle de la plaque inférieure, afin de répartir de manière homogène la masse de l'antenne.

De manière particulièrement avantageuse, les joints à ressorts conducteurs peuvent être prévus entre la partie mâle et la partie femelle pour assurer de manière fiable et simple le contact électrique permanent entre la partie mâle et la partie femelle.

Les plaques supérieure et inférieure sont par exemple de forme rectangulaire, permettant d'assurer une continuité de forme des plaques supérieure et inférieure lors de leur extension longitudinale.

Dans une variante de réalisation, les plaques longitudinales sont au nombre de quatre, de forme triangulaire, deux plaques étant reliées par un côté aux côtés d'extrémité longitudinales de la plaque supérieure et deux plaques étant reliées par un côté aux côtés d'extrémité longitudinales de la plaque inférieure, les plaques longitudinales s'étendant des côtés en regard des plaques inférieure et supérieure se raccordant au niveau d'un angle.

Par exemple, les paires de plaques longitudinales, se raccordant au niveau d'un angle, se raccordent au moyen d'un élément de raccordement relié à chacune des dites plaques longitudinales par une deuxième charnière, ledit élément de raccordement isolant électriquement les plaques longitudinales qu'elles relient et étant raccordé électriquement à la plaque inférieure et à la plaque supérieure.

De manière avantageuse, l'antenne comporte des moyens de soutien des extrémités longitudinales de l'antenne, lesdits moyens de soutien étant de hauteur variable. Les moyens de soutien permettent d'augmenter la rigidité de l'antenne, et ainsi de maintenir une configuration symétrique de l'antenne par rapport à un plan passant par les deux extrémités longitudinales de l'antenne et parallèle aux plaques supérieure et inférieure.

Dans une autre variante de réalisation, la plaque inférieure peut être un plan de masse.

Les plaques longitudinales peuvent être au nombre de deux de forme triangulaire, chaque plaque étant reliée par un côté aux côtés d'extrémité longitudinales de la plaque supérieure et se raccordant au niveau d'un angle à la plaque inférieure.

## BRÈVE DESCRIPTION DES DESSINS

La présente invention sera mieux comprise à l'aide de la description qui va suivre et des dessins annexés, sur lesquels :

- la figure 1 est une vue en perspective d'une antenne Strip-line de l'état de la technique,
- la figure 2 est vue en perspective d'un exemple préféré de réalisation d'une antenne Strip-line selon la présente invention,
- la figure 3 est une vue de détail de l'antenne de la figure 2,
- la figure 4 est une vue d'un autre détail de l'antenne de la figure 2,
- la figure 5 est une vue d'un élément isolé de l'antenne de la figure 2,
- la figure 6 est une perspective d'une variante d'une antenne Strip-line de la figure 2,
- la figure 7 est une vue en perspective d'une autre variante de réalisation de l'antenne de la figure 2,
- la figure 8 est une vue en perspective d'un autre exemple de réalisation d'une antenne selon la présente invention.

## EXPOSÉ DÉTAILLÉ DE MODES DE RÉALISATION PARTICULIERS

Sur la figure 2, on peut voir un exemple préféré de réalisation d'une antenne Strip-line selon la présente invention comportant une plaque supérieure 2 et une plaque inférieure 4 disposées parallèlement l'une en face de l'autre. Ces plaques 2 et 4 sont, dans l'exemple représenté de forme rectangulaire. Chaque plaque inférieure 2 et supérieure 4 comporte à chacune de ses extrémités longitudinales, une plaque longitudinale 6, 8, 10, 12 respectivement. Les plaques longitudinales 6, 8, 10, 12 sont, dans l'exemple représenté de forme triangulaire et sont reliées par un côté 6.1, 8.1, 10.1, 12.1 à un côté 2.1, 2.2, 4.1, 4.2 des plaques supérieure et inférieure 2, 4 respectivement.

Les plaques longitudinales 6, 10 de chaque plaque supérieure 2 et inférieure 4 disposées du même côté se raccordent au niveau d'un angle 6.2, 10.2, opposé au côté 6.1, 10.1 relié à la plaque supérieure 2, inférieure 4 respectivement.

Les plaques longitudinales 8, 12 de chaque plaque supérieure 2 et inférieure 4, disposées du même côté se raccordent au niveau d'un angle 8.2, 12.2, opposé au côté 8.1, 12.1 relié à la plaque supérieure 2, inférieure 4 respectivement.

Ainsi vue de face, l'antenne a la forme d'un hexagone comportant deux côtés parallèles de plus grande longueur et quatre côtés parallèles deux à deux de plus petite longueur.

Une extrémité longitudinale est attaquée par un amplificateur de puissance radio fréquence, et la seconde extrémité est chargée sur une résistance de puissance, d'impédance de 50 ohms par exemple.

Les plaques supérieures 2 et inférieure 4 et les plaques longitudinales 6, 8, 10, 12 délimitent un espace intérieur E.

Selon la présente invention, l'espace intérieur est de dimensions variables afin d'optimiser l'antenne aux cartes électroniques à tester.

La présente invention prévoit de pouvoir modifier la distance h séparant les plaques supérieure 2 et inférieure 4.

Pour cela, il est prévu que les plaques longitudinales 6, 8, 10, 12 soient montées mobiles par rapport aux plaques supérieure 2 et inférieure 4.

Afin de permettre le réglage en hauteur de l'antenne, on rend la structure mobile. Cette mobilité permet de ne pas déformer les parties liées à l'amplificateur et à la résistance 50 Ohms.

Nous décrirons en détail les plaques longitudinales 6, 10, la description est similaire pour les plaques 8, 12.

Dans l'exemple représenté, une liaison pivot 16, par exemple une charnière de type charnière à piano est prévue entre la plaque longitudinale 6 et la plaque supérieure 2 le long des côtés 2.1 et 6.1.

Ainsi la plaque longitudinale 6 est mobile en rotation par rapport à la plaque supérieure autour d'un axe X situé le long du côté 2.1 de la plaque supérieure 2.

La plaque longitudinale 10 est montée mobile en rotation sur la plaque inférieure 4 au niveau d'un côté 4.1 le long d'un axe X' au moyen d'une première liaison pivot 17, l'axe X' étant parallèle à l'axe X. La liaison pivot 17 est par exemple une charnière identique à la charnière 16.

En outre, les plaques longitudinales 6, 10 se raccordent au niveau d'un angle 6.2, 10.2, également de manière mobile.

Il est alors prévu deux deuxièmes liaisons pivots 18, 20 reliant les plaques longitudinales 6, 10 à un élément de raccordement 22. Ces liaisons pivots sont parallèles aux premières liaisons pivots 16, 17.

Les liaisons pivots 18, 20 sont par exemple des charnières 18, 20 du même type que les charnières 16, 17.

Ainsi, il est possible de modifier la distance h entre les plaques supérieure 2 et inférieure 4.

Par conséquent en appliquant la relation (I), une diminution de h permet d'augmenter le champ électromagnétique.

Pour doubler le champ électromagnétique, il suffit de diviser par deux la hauteur h, alors qu'il faut multiplier par quatre la puissance délivrée par l'amplificateur.

Le coût global d'un ensemble « amplificateur et antenne Strip-line selon la présente invention » est donc très inférieur à un ensemble « amplificateur et antenne Strip-line standard » L'antenne selon la présente invention permet d'optimiser au mieux la puissance disponible et de s'adapter au plus près des dimensions des cartes électroniques.

Les charnières 16, 17, 18, 20 sont réalisées en matériau conducteur pour assurer une bonne conductivité électrique entre les différentes parties de l'antenne.

On pourrait envisager d'utiliser des conducteurs filaires rapportés, chevauchant les charnières, ceux-ci étant répartis de manière homogène sur la largeur de l'antenne.

L'élément de raccordement 22 comporte un bloc isolant, par exemple en téflon reliant mécaniquement les plaques 6 et 10 et les isolant électriquement, et un connecteur, du type prise N, dont l'âme est reliée à la plaque supérieure 2, et le corps est relié à la plaque inférieure 4.

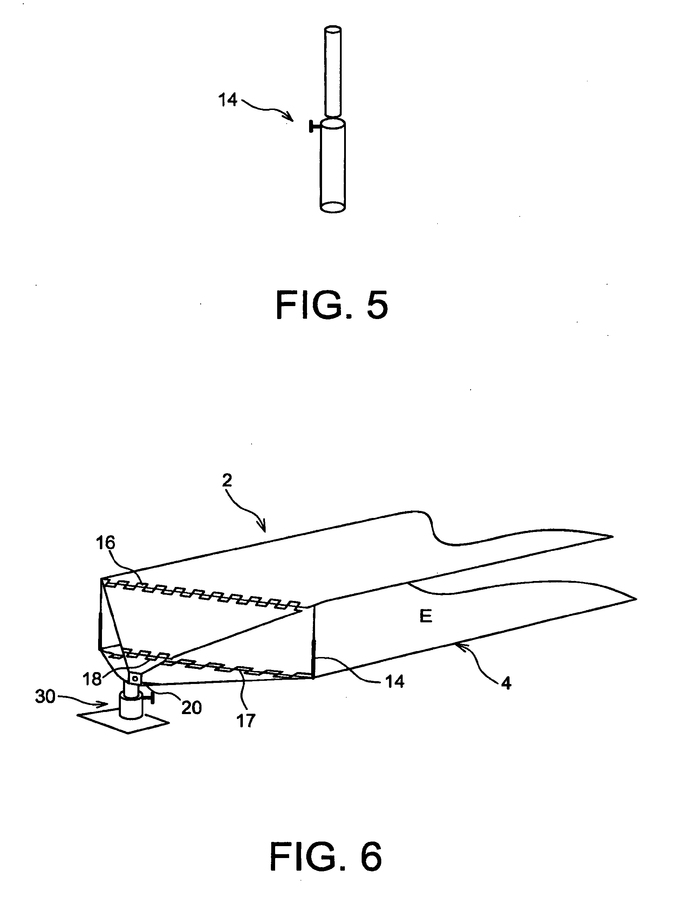

En outre, dans le cas où l'antenne comporte des entretoises 14, celles-ci sont prévues de telle sorte qu'elles soient de hauteur variable, comme cela est représenté sur la figure 5. Celles-ci peuvent être par exemple télescopiques. Ces entretoises sont réalisées par exemple en matériau plastique isolant électrique.

Dans l'exemple représenté, les entretoises 14 sont disposées aux quatre coins en regard des plaques supérieure 2 et inférieure 4.

Le réglage des entretoises peut s'effectuer manuellement au moyen d'une vis. On pourrait prévoir d'autres moyens, type crémaillère. Par ailleurs la variation de hauteur des entretoises pourrait être commandée par moteurs électriques.

Dans l'exemple préféré de réalisation, il est avantageusement prévu que les plaques supérieure 2 et inférieure 4 soit de longueur 1 variable, ce qui permet de réaliser une antenne Strip-line dont les modes de résonance sont déplaçables lorsque l'antenne est utilisée au delà de la fréquence de coupure.

Nous décrirons en détail la plaque supérieure 2, la plaque inférieure 4 étant de structure similaire.

Dans l'exemple représenté, la plaque supérieure 2 est télescopique. Celle-ci comporte une partie femelle 24, et une partie mâle 26, la partie mâle pénétrant dans la partie femelle 24 et étant apte à coulisser dans la partie femelle 24 pour modifier la longueur 1 de la plaque supérieure 2. En outre, le contact électrique entre la partie mâle 26 et la partie femelle 26 est assuré.

Ainsi il est possible de modifier la longueur de la plaque supérieure dans un rapport proche de 2.

Un jeu j est prévu entre la partie mâle et la partie femelle afin de rendre le coulissement aisé.

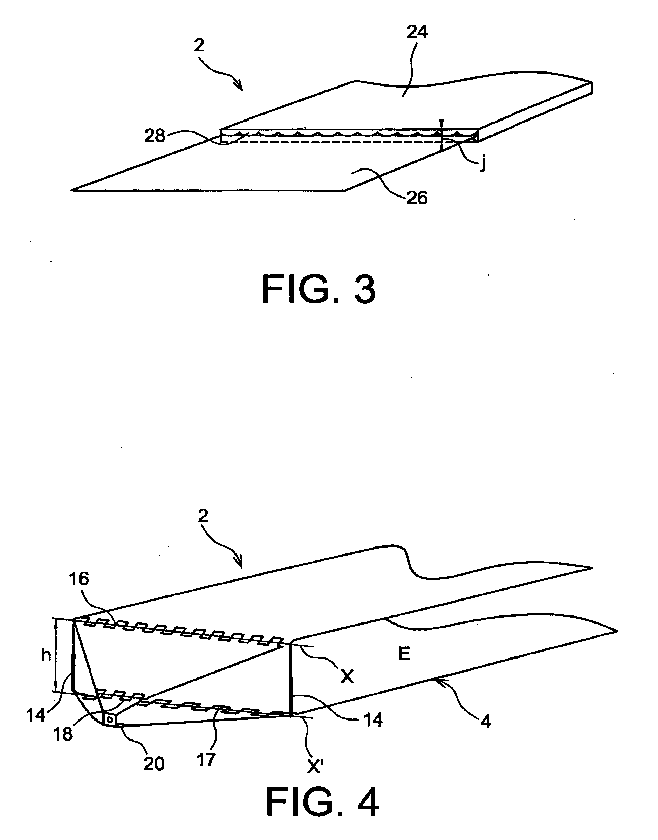

De manière particulièrement avantageuse pour éviter que le jeu j ne produise des ruptures de conduction électrique, il est prévu de disposer des joints à ressort 28 en matériau conducteur électrique entre la partie mâle 26 et la partie femelle 24, comme cela est représenté sur la figure 3, afin d'assurer un contact électrique permanent entre la partie femelle 24 et la partie mâle, tout en permettant un coulissement aisé. La plaque supérieure 2 forme donc, d'un point de vue électrique, une seule pièce.

Des moyens, par exemple de type à vis pour immobiliser les deux parties 24 et 26 l'une par rapport à l'autre peuvent être prévus.

Le joint conducteur peut être suffisamment rigide pour assurer une immobilisation relative des deux parties 24, 26.

Dans les cas des antennes Strip-line de l'état de la technique, les différentes parties étant rigidement liées l'une à l'autre, l'antenne conserve naturellement sa forme hexagonale.

Or, selon la présente invention, les différentes parties étant mobiles l'une par rapport à l'autre, on peut prévoir de manière avantageuse des moyens de soutien des extrémités de l'antenne formées par les éléments de raccordement 22, pour améliorer la rigidité de l'antenne.

Dans l'exemple représenté, ces moyens de soutien sont formés par des colonnettes télescopiques 30 de hauteur réglable et dont la hauteur est ajustée en fonction de la modification de dimensions de l'espace intérieur de l'antenne. Ainsi l'antenne conserve une forme déterminée. Les colonnettes 28 sont, par exemple du même type que les entretoises télescopiques 14.

.On pourrait prévoir que les frottements entre les différentes pièces mobiles soient suffisants pour assurer le maintien de l'antenne dans une position déterminée.

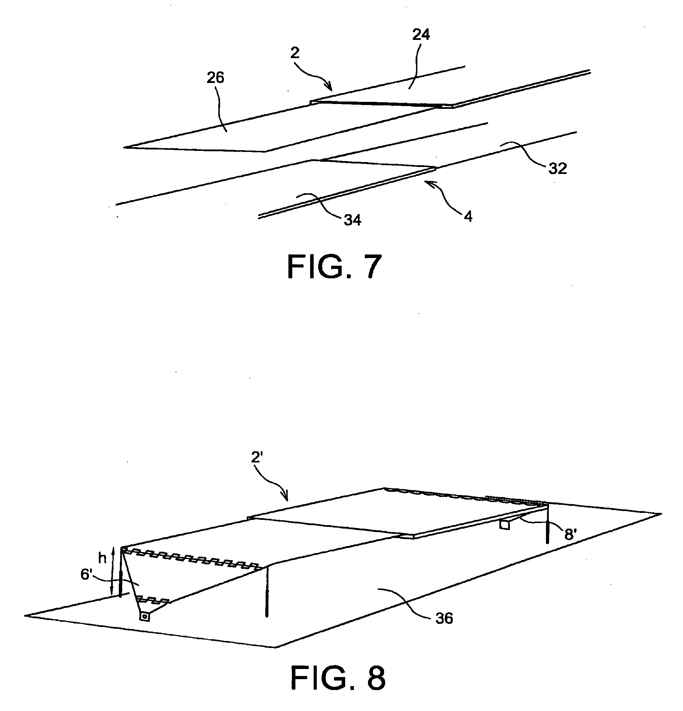

Sur le schéma de la figure 7, on peut voir une variante de l'antenne de la figure 2, dans laquelle la partie mâle 24 de la plaque supérieure 2 et la partie mâle 32 de la plaque inférieure 4 sont disposées en quinconce, ce qui offre l'avantage de répartir la masse de l'antenne de manière homogène sur l'ensemble de la structure. En effet, les parties femelles 24, 34 ont généralement une masse supérieure à celle des parties mâles.

Sur la figure 1, on peut voir l'exemple de réalisation d'une antenne dans lequel les parties mâles sont l'une au-dessus de l'autre.

Les parties mâles et femelles peuvent être réalisées dans le même matériau.

Il est bien entendu que l'on peut prévoir que l'antenne ne comporte pas de plaques supérieure 2 et inférieure 4 de longueur variable. Dans ce cas, seules les plaques d'extrémités seraient mobiles permettant une modification de la hauteur de l'antenne.

Il est également bien entendu qu'une antenne, dont seules les plaques supérieure et inférieure sont de longueur variable ne sort pas du cadre de la présente invention.

Dans un autre exemple de réalisation représenté sur la figure 8, l'antenne Strip-line selon la présente invention comporte une plaque supérieure 2' et des plaques longitudinales 6' et 8' raccordées aux extrémités longitudinales de la plaque supérieure 2', cet ensemble reposant sur un plan de masse 36.

L'ensemble formé par la plaque supérieure 2', des plaques longitudinales 6' et 8' est articulé d'une manière similaire à celle décrite précédemment et permet de réaliser une antenne Strip-line de dimensions variables.

Dans cet exemple, la plaque supérieure 2' est de longueur variable et les plaques latérales sont montées mobiles sur la plaque supérieure 2', mais on pourrait prévoir que l'antenne comporte uniquement une plaque supérieure 2' de longueur variable ou uniquement des plaques latérales mobiles sur la plaque supérieure 2'.

Les différentes parties de l'antenne sont par exemple en cuivre, en laiton ou en aluminium.

Une antenne comportant des plaques supérieure et inférieure et des plaques longitudinales de formes différentes de celles décrites ne sort pas du cadre de la présente invention.

**Revendications**

1. Antenne d'essais de compatibilité électromagnétique comportant une plaque supérieure (2) et une plaque inférieure (4) d'axes longitudinaux parallèles, maintenues à une distance (h) l'une de l'autre, reliées mécaniquement à chacune de leurs extrémités longitudinales (2.1, 2.2, 4.1, 4.2) par des plaques longitudinales (6, 8, 10, 12), lesdites plaques supérieure (2) et inférieure (4) et lesdites plaques longitudinales (6, 8, 10, 12) délimitant un espace (E), **caractérisée en ce que** les plaques supérieure (2) et inférieure (4) et les plaques longitudinales (6, 8, 10, 12) sont montées mobiles les unes par rapport aux autres afin de délimiter un espace de dimensions aptes à être modifiées, la plaque supérieure ou les plaques supérieure et inférieure est/sont de dimension longitudinale variable, celle/s-ci ayant avec les plaques longitudinales, une première liaison pivot (16, 17)sur des extrémités longitudinales (2.1, 2.2, 4.1, 4.2).

2. Antenne selon la revendication 1, dans laquelle la plaque supérieure (2) et la plaque inférieure (4) sont maintenues à la distance (h) prédéterminée au moyen d'entretoises (14) de hauteur variable.

3. Antenne selon la revendication 2, dans laquelle les entretoises (14) sont télescopiques.

4. Antenne selon l'une des revendications 1 à 3, dans laquelle les premières liaisons pivots (16, 17) sont en matériau conducteur électrique.

5. Antenne selon l'une des revendications 1 à 4, dans laquelle la plaque supérieure (2) est du type télescopique, comportant une partie mâle (26) et une partie femelle (24), les parties mâle (24) et femelle (26) étant en contact électrique permanent.

6. Antenne selon l'une des revendications 1 à 5, dans laquelle la plaque supérieure (2) et la plaque inférieure (4) sont du type télescopique, chaque plaque supérieure (2) et inférieure (4) comportant une partie mâle (26, 32) et une partie femelle (24, 34), les parties mâle (26, 32) et femelle (24, 34) étant en contact électrique permanent.

7. Antenne selon la revendication 6, dans laquelle la partie mâle (26) de la plaque supérieure (2) est en regard de la partie mâle (32) de la plaque inférieure (4).

8. Antenne selon la revendication 5, 6 ou 7, dans laquelle des joints à ressorts conducteurs (28) sont prévus entre la partie râle (26, 32) et la partie femelle (24, 34) pour assurer le contact électrique permanent entre la partie mâle (26, 32) et la partie femelle (24, 34).

9. Antenne selon l'une des revendications 1 à 8, dans laquelle les plaques supérieure (2) et/ou inférieure (4) sont de forme rectangulaire.

10. Antenne selon la revendication 9, dans laquelle les plaques longitudinales (6, 8, 10, 12) sont au nombre de quatre de forme triangulaire, deux plaques (6, 8) étant reliées par un côté (6.1, 8.1) aux côtés (2.1, 2.2) d'extrémité longitudinales de la plaque supérieure (2) et deux plaques (10, 12) étant relié par un côté (10.1, 12.1) aux côtés (4.1, 4.2) d'extrémité longitudinales de la plaque inférieure (4), les plaques longitudinales s'étendant des côtés en regard des plaques inférieure et supérieure se raccordant au niveau d'un angle.

11. Antenne selon la revendication précédente, dans laquelle les paires de plaques longitudinales, se raccordant au niveau d'un angle, se raccordent au moyen d'un élément de raccordement (22) reliées à chacune des dites plaques longitudinales par une deuxième liaison pivot (18, 20), ledit élément de raccordement isolant électriquement les plaques longitudinales qu'elles relient et étant raccordé électriquement à la plaque inférieure et à la plaque supérieure.

12. Antenne selon la revendication 10 ou 11, comportant des moyens de soutien (30) des extrémités longitudinales de l'antenne, lesdits moyens de soutien étant de hauteur variable.

13. Antenne selon l'une quelconque des revendications 1 à 5, dans laquelle la plaque inférieure (4) est un plan de masse (36).

14. Antenne selon la revendication 13, dans laquelle les plaques longitudinales sont au nombre de deux de forme triangulaire, chaque plaque étant reliée par un côté aux côtés d'extrémité longitudinales de la plaque supérieure et se raccordant au niveau d'un angle à la plaque inférieure.

**Patentansprüche**

1. Antenne zur elektromagnetischen Kompatibilitätsprüfung mit einer oberen Platte (2) und einer unteren Platte (4) mit parallelen Längsachsen, die in einem Abstand (h) voneinander gehalten sind, die an jedem ihrem Längsenden (2.1, 2.2, 4.1, 4.2) durch Längsplatten (6, 8, 10, 12) mechanisch verbunden sind, wobei die obere Platte (2) und die untere Platte (4) und die Längsplatten (6, 8, 10, 12) einen Raum (E) begrenzen, **dadurch gekennzeichnet, dass** die obere Patte (2) und die untere Platte (4) und die Längsplatten (6, 8, 10, 12) in Bezug aufeinander bewegbar angebracht sind, um einem Raum mit Abmessungen, die modifiziert werden können, zu begrenzen, wobei die obere Platte oder die obere und die untere Platte eine variable Längsabmessung aufweisen und diese mit den Längsplatten ein erstes Scharniergelenk (16, 17) an Längsenden (2.1, 2.2, 4.1, 4.2) aufweist bzw. aufweisen.

2. Antenne nach Anspruch 1, wobei die obere Platte (2) und die untere Platte (4) mittels Streben (14) variabler Höhe in dem vorgegebenen Abstand (h) gehalten sind.

3. Antenne nach Anspruch 2, wobei die Streben (14) Teleskopstreben sind.

4. Antenne nach einem der Ansprüche 1 bis 3, wobei die ersten Scharniergelenke (16, 17) aus einem elektrisch leitenden Material sind.

5. Antenne nach einem der Ansprüche 1 bis 4, wobei die obere Platte (2) vom Teleskoptyp ist, der eine männliche Partie (26) und eine weibliche Partie (24) aufweist, wobei die männliche Partie (24) und die weibliche Partie (26) in permanentem elektrischem Kontakt stehen.

6. Antenne nach einem der Ansprüche 1 bis 5, wobei die obere Platte (2) und die untere Platte (4) vom Teleskoptyp sind, die obere Platte (2) und die untere Platte (4) jeweils eine männliche Partie (26, 32) und eine weibliche Partie (24, 34) aufweisen, wobei die männlichen Partien (26, 32) und die weiblichen Partien (24, 34) in permanentem elektrischem Kontakt stehen.

7. Antenne nach Anspruch 6, wobei die männliche Partie (26) der oberen Platte (2) der männlichen Partie (32) der unteren Platte (4) gegenüberliegend ist.

8. Antenne nach Anspruch 5, 6 oder 7, wobei leitfähige Federverbindungen (28) zwischen der männlichen Partie (26, 32) und der weiblichen Partie (24, 34) zur Sicherstellung des permanenten elektrischen Kontakts zwischen der männlichen Partie (26, 32) und der weiblichen Partie (24, 34) vorgesehen sind.

9. Antenne nach einem der Ansprüche 1 bis 8, wobei die obere Platte (2) und/oder die untere Platte (4) von rechteckiger Form sind.

10. Antenne nach Anspruch 9, wobei die Längsplatten (6, 8, 10, 12) in einer Zahl von vier mit Dreieckform vorliegen, wobei zwei Platten (6, 8) über eine Seite (6.1, 8.1) mit Längsendeseiten (2.1, 2.2) der oberen Platte (2) verbunden sind und zwei Platten (10, 12) über eine Seite (10.1, 12.1) mit Längsendeseiten (4.1, 4.2) der unteren Platte (4) verbunden sind, wobei sich die Längsplatten im Hinblick auf die untere und die obere Platte von den Seiten erstrecken und in einer Winkelform verbunden sind.

11. Antenne nach dem vorhergehenden Anspruch, wobei die Paare von Längsplatten, die in einer Winkelform verbunden sind, mittels eines Verbindungselements (22) verbunden sind, das mit jeder der Längsplatten über ein zweites Scharniergelenk (18, 20) verbunden ist, wobei das Verbindungselement die Längsplatten, die sie verbinden, elektrisch isoliert und elektrisch mit der unteren und der obere Platte verbunden ist.

12. Antenne nach Anspruch 10 oder 11 mit Trägermitteln (30) der Längsenden der Antenne, wobei die Trägermittel von variabler Höhe sind.

13. Antenne nach einem der Ansprüche 1 bis 5, wobei die untere Platte (4) eine Erdungsebene (36) ist.

14. Antenne nach Anspruch 13, wobei die Längsplatten in einer Zahl von zwei mit einer Dreieckform vorhanden sind, wobei jede Platte über eine Seite mit Längsendeseiten der oberen Platte verbunden ist und in einer Winkelform mit der unteren Platte verbunden ist.

# EP 2 122 373 B1

**Claims**

1. Antenna to perform electromagnetic compatibility tests comprising an upper plate (2) and a lower plate (4) with parallel longitudinal axes, maintained at a distance (h) from each other and connected mechanically at each of their longitudinal ends (2.1, 2.2, 4.1, 4.2) by longitudinal plates (6, 8, 10, 12), said upper plate (2) and lower plate (4) and said longitudinal plates (6, 8, 10, 12) delimiting a space (E), **characterised in that** the upper plate (2) and the lower plate (4) and the longitudinal plates (6, 8, 10, 12) are mounted free to move with respect to each other to delimit a space with dimensions that can be modified, the upper plate or the upper plate and the lower plate has/have variable longitudinal dimension, the upper plate or the upper plate and the lower plate having with the longitudinal plates, a first pivot (16, 17) on the longitudinal ends (2.1, 2.2, 4.1, 4.2).

2. Antenna according to claim 1, in which the upper plate (2) and the lower plate (4) are kept at a predetermined distance (h) by means of variable height spacers (14).

3. Antenna according to claim 2, in which the spacers (14) are telescopic.

4. Antenna according to any one of claims 1 to 3, in which the first pivot links (16, 17) are made of an electrically conducting material.

5. Antenna according to any one of claims 1 to 4, in which the upper plate (2) is of the telescopic type, comprising a male part (26) and a female part (24), the male part (24) and the female part (26) being permanently in electrical contact.

6. Antenna according to any one of claims 1 to 5, in which the upper plate (2) and the lower plate (4) are of the telescopic type, each upper plate (2) and lower plate (4) comprising a male part (26, 32) and a female part (24, 34), the male part (26, 32) and the female part (24, 34) being permanently in electrical contact.

7. Antenna according to claim 6, in which the male part (26) of the upper plate (2) is above the male part (32) of the lower plate (4).

8. Antenna according to claim 5, 6 or 7, in which conducting spring joints (28) are provided between the male part (26, 32) and the female part (24, 34) to make a permanent electrical contact between the male part (26, 32) and the female part (24, 34).

9. Antenna according to one of claims 1 to 8, in which the upper plate (2) and/or the lower plate (4) are rectangular in shape.

10. Antenna according to claim 9, comprising four longitudinal plates (6, 8, 10, 12), said longitudinal plates being triangular in shape, two plates (6, 8) being connected through one side (6.1, 8.1) to the longitudinal end sides (2.1, 2.2) of the upper plate (2) and two plates (10, 12) being connected through one side (10.1, 12.1) to the longitudinal ends (4.1, 4.2) of the lower plate (4), the longitudinal plates extending along the sides facing the lower and upper plates being connected at a summit.

11. Antenna according to the previous claim, in which the pairs of longitudinal plates connected at a summit are connected by means of a connection element (22) connected to each of said longitudinal plates through a second pivot link (18, 20), said connection element electrically isolating the longitudinal plates that they connect and being electrically connected to the lower plate and to the upper plate.

12. Antenna according to claim 10 or 11, comprising means of supporting (30) the longitudinal ends of the antenna, said support means being of variable height.

13. Antenna according to any one of claims 1 to 5, in which the lower plate (4) is a ground plane (36).

14. Antenna according to claim 13, comprising two triangular longitudinal plates, each plate being connected through one side to the longitudinal end sides of the upper plate and connecting at a summit to the lower plate.

FIG. 1

FIG. 2

# FIG. 3

# FIG. 4

14

## FIG. 5

2

16

E

18    14    4

30    20

17

## FIG. 6

FIG. 7

FIG. 8

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5585808 A